# EUROPÄISCHE PATENTANMELDUNG

(11) **EP 2 101 350 A1**
(43) Veröffentlichungstag der Anmeldung: **16.09.2009**
(21) Anmeldenummer: 09154180.5
(22) Anmeldetag: 03.03.2009
(51) Int. Cl.: H01L 21/60

(54) **Verfahren und Drahtbonder zur Herstellung einer Golddraht-Bondverbindung**

(30) Priorität: 12.03.2008 DE 102008013756
(71) Anmelder: F&K Delvotec Bondtechnik GmbH, 85521 Ottobrunn (DE)
(72) Erfinder: Farassat, Farhad, 82024 Taufkirchen (DE)
(74) Vertreter: Popp, Eugen

(57) **Zusammenfassung**

Verfahren zur Herstellung einer Gruppe von Golddraht-Bonddrahtverbindungen unter Einsatz eines bei den Bondschritten mit Ultraschall beaufschlagten und gegen den Bonddraht auf einem Substrat angedrückten Bondwetkzeugs, das in einem Bondkopf gehaltert ist, wobei die Winkellage des Bonddrahtes relativ zu einer festen Raumrichtung bei den Bondverbindungen der Gruppe variiert, wobei die Orientierung des Bondkopfes mit dem Bondwerkzeug der Winkellage des Bonddrahtes bei der jeweils zur erzeugenden Bondverbindung nachgeführt und anschließend der Bondschritt ausgeführt wird.

## Beschreibung

Die Erfindung betrifft ein Verfahren zur Herstellung von Golddraht-Bondverbindungen nach dem Oberbegriff des Anspruchs 1 sowie einen zur Ausführung eines solchen Verfahrens ausgebildeten Drahtbonder.

Drahtbondverfahren und Drahtbonder sind seit langem in vielgestaltigen Ausführungen bekannt und werden seit Jahrzehnten in der Serienproduktion von Halbleiterschaltkreisen und anderen Elektronik-Komponenten eingesetzt. Im Verlaufe ihrer langen technischen Entwicklung hat sich eine zunehmende Differenzierung der Verfahrensführung und Gerätetechnik in Abhängigkeit vom Material und den geometrischen Parametern des verwendeten Bonddrahtes ergeben. Heute gelten für die Entwicklung und den industriellen Einsatz von mit Aluminiumdraht arbeitenden Bondverfahren und Bondern gänzlich andere Anforderungen und Randbedingungen als bei Verfahren und Geräten, die Gold-Bonddrähte oder auch Kupfer-Bonddrähte verarbeiten.

Bei vielen industriellen Bondverfahren wird in einem Verfahrenszyklus eine Gruppe von Bondverbindungen zwischen Substraten hergestellt, die derart konzentrisch um ein Arbeitstisch-Zentrum arrangiert sind, dass die jeweils zwischen den Bondstellen verlaufenden Bonddrähte radial zu diesem Zentrum ausgerichtet sind und durch die Größe der zu bearbeitenden Gruppe von Substraten bestimmte Winkelabstände bzw. -inkremente zueinander haben.

Ein in Ultraschall-Schwingungen versetztes Bondwerkzeug, das zum Andrücken und Anbringen des Bonddrahtes am jeweiligen Substrat dient, ist bei üblichen Golddrahtbondern fest in einem Winkel starr angeordneten Bondkopf angebracht. Die durch den Andruck des Bondwerkzeugs an den Golddraht und die gleichzeitig wirkende Schwingungsenergie erzeugte stoffschlüssige Verbindung mit der Substratoberfläche ist in ihrer Qualität abhängig vom Winkel, der bei der jeweiligen Bondverbindung zwischen der Schwingungsrichtung des Bondwerkzeugs und der Längsrichtung des Bonddrahtes besteht. Es hat sich herausgestellt, dass es bei größeren Winkelabweichungen deutliche Qualitätsmängel geben kann. Aus diesem Grund hat es sich sogar eingebürgert, bei höchsten Qualitätsansprüchen einen sogenannten "Security Bump" nachträglich und zusätzlich auf einen einmal erzeugten Bondkontakt aufzubringen. Es versteht sich, dass dies ein technologisch aufwendiges Vorgehen ist, welches die Kosten für auf diese Weise erzeugte Bondverbindungen und somit die entsprechenden Komponenten erhöht.

Der Erfindung liegt daher die Aufgabe zugrunde, ein verbessertes Bondverfahren und einen verbesserten Drahtbonder der in Rede stehenden Art bereitzustellen, welche Bondverbindungen mit höchster Qualität mit vertretbarem Aufwand und somit zur akzeptablen Kosten liefern.

Diese Aufgabe wird in ihrem Verfahrensaspekt durch ein Verfahren mit den Merkmalen des Anspruchs 1 und in ihrem Vorrichtungsaspekt durch einen Drahtbonder mit den Merkmalen des Anspruchs 6 gelöst. Zweckmäßige Fortbildungen des Erfindungsgedankens sind Gegenstand der abhängigen Anspruche.

Die Erfindung schließt den wesentlichen Gedanken ein, den Bondkopf (und damit das Bondwerkzeug) in seiner Orientierung an die Ausrichtung des Bonddrahtes vor dem jeweiligen Bondschritt derart anzupassen, dass unzulässig große Winkelabweichungen zwischen der Draht-Längsrichtung und der Schwingungsrichtung vermieden werden, so dass unabhängig von der konkreten Ausrichtung der zwischen den Bondstellen verlaufenden Bonddrähte eine hohe Qualität der jeweiligen Bondverbindung gesichert wird. Dies ermöglicht den Verzicht auf die erwähnten Security Bumps und somit Vereinfacherungen und Beschleunigungen des Bondverfahrens und deutliche Kosteneinsparungen. Mit der Erfindung erfolgt auf dem Gebiet der Golddraht-Bondverfahren und -bonder eine Abkehr vom etablierten Stand der Technik; das Verfahren und der entsprechende Drahtbonder sind aber vorteilhaft auch für Kupferdraht-Bondprozesse einsetzbar.

In einer Ausführung der Erfindung ist vorgesehen, dass die Orientierung des Bondkopfes mit der Winkellage des Bonddrahtes in Übereinstimmung gebracht wird. Dies bedeutet, dass in einem Bearbeitungszyklus, in dem eine Gruppe von Bondverbindungen mit unterschiedlichen Bonddraht-Winkellagen zwischen den einzelnen Substraten hergestellt wird, der Bondkopf (d.h. die Schwingungsrichtung des Bondwerkzeugs) in die jeweilige Winkellage des Bonddrahtes gebracht werden kann. Bei dieser Ausführung ist daher eine im wesentlichen kontinuierliche Drehung des Bondkopfes oder jedenfalls eine schrittweise Drehung mit kleinen Winkelabständen erforderlich.

In einer vereinfachten Ausführung ist vorgesehen, dass die Orientierung des Bondkopfes aus mehreren verfügbaren Winkellagen, deren Anzahl kleiner ist als die Anzahl der Winkellagen des Bonddrahtes bei der Gruppe von Bondverbindungen, derart ausgewählt wird, dass die Abweichung gegenüber der Winkellage des Bonddrahtes bei jeder zu erzeugenden Bondverbindungen minimal wird. Bei dieser Ausführung kann nur eine relativ begrenzte Anzahl von möglichen Winkellagen des Bondkopfes (beispielsweise versetzt um jeweils 30°C) realisiert werden, um mit verringertem konstruktiven Aufwand auszukommen und dennoch relativ hohen Qualitätsansprüchen zu genügen. Bei dieser Verfahrensführung wird also der Bondkopf jeweils in diejenige der anwählbaren Winkellagen gebracht, die der Winkellage des Bonddrahtes zwischen den jeweiligen Substraten am nächsten kommt, ohne dass aber in den meisten Fällen eine völlige Parallelität erreicht wird.

Eine wichtige Fortbildung des Erfindungsgedanken besteht darin, dass auch eine Einrichtung zum Abflammen eines Bond-Tails zusammen mit dem Bondkopf der Winkellage des Bonddrahtes nachgeführt wird.

Die konstruktiven Merkmale eines zur Ausführung der Erfindung geeigneten Drahtbonders ergeben sich im wesentlichen aus den vorstehend beschriebenen Verfahrensaspekten und sollen hier nicht nochmals genauer erläutert werden. Hinzuweisen ist darauf, dass ein solcher Drahtbonder vorteilhafter Weise eine programmierbare Steuerung hat, die eine Überführung des Bondkopfes in die durch Anordnung der Bondsubstrate auf dem Arbeitstisch vorgegebenen Winkellagen des Bonddrahtes oder jedenfalls eine hinreichende Annäherung an diese Winkellagen sichert.

Es ist auch möglich, vor der Ausführung eines Bondschrittes jeweils die tatsächliche Winkellage des Bonddrahtes zwischen den vorgesehenen Bondstellen in Echtzeit zu erfassen und die Ausrichtung des Bondkopfes im Ansprechen an dieses Messergebnis nachzuführen.

Bei der weiter oben angesprochenen konstruktiv vereinfachten Anordnung, bei der nur eine relativ kleine Anzahl an Winkelpositionen anfahrbar ist, ist das Vorsehen einer Vergleichereinheit sinnvoll, die eine vorgegebenen oder erfasste Winkellage des Bonddrahtes mit den verfügbaren Winkelpositionen des Bondkopfes vergleicht und im Ergebnis des Vergleiches ein Signal zur Ansteuerung derjenigen Winkellage ausgibt, die die kleinste Differenz zur Winkellage des Drahtes hat.

Im Hinblick auf die weiter oben bereits erwähnte Abflammeinrichtung ist darauf hinzuweisen, dass beim Abflammen eines Bond-Tails eine bestimmte räumliche Beziehung zwischen dem Tail-Verlauf und dem aus der Abflammlanze austretenden Gasstrom gegeben sein sollte. Daher ist auch die Abflammlanze winkelverstellbar auszuführen, und zwar am sinnvollsten zusammen und in Übereinstimmung mit dem Bondkopf (und somit dem Bondwerkzeug). Da aber die Abflammlanze ohnedies bei jedem Bondschritt an die Bondstelle heran und nach dem Abflammen (und vor dem nächsten Bondschritt) wieder in eine Ruhestellung gebracht werden muss, erfordert die Realisierung dieses Aspektes zusätzliche gedankliche Schritte und zusätzlichen konstruktiven Aufwand.

Eine vorteilhafte Lösung sieht eine, insbesondere dreidimensionale, Kurvenscheiben-Steuerung der Halterung der Abflammlanze zum Heranführen an die jeweilige Bondstelle vor, welche mit der Winkelverstellung des Bondkopfes koordiniert ist.

## Patentansprüche

1. Verfahren zur Herstellung einer Gruppe von Golddraht-Bonddrahtverbindungen unter Einsatz eines bei den Bondschritten mit Ultraschall beaufschlagten und gegen den Bonddraht auf einem Substrat angedrückten Bondwerkzeugs, das in einem Bondkopf gehaltert ist, wobei die Winkellage des Bonddrahtes relativ zu einer festen Raumrichtung bei den Bondverbindungen der Gruppe variiert,
**dadurch gekennzeichnet, dass**
die Orientierung des Bondkopfes mit dem Bondwerkzeug der Winkellage des Bonddrahtes bei der jeweils zur erzeugenden Bondverbindung nachgeführt und anschließend der Bondschritt ausgeführt wird.

2. Verfahren nach Anspruch 1, wobei die Orientierung des Bondkopfes mit der Winkellage des Bonddrahtes in Übereinstimmung gebracht wird.

3. Verfahren nach Anspruch 1, wobei die Orientierung des Bondkopfes aus mehreren verfügbaren Winkellagen, deren Anzahl kleiner ist als die Anzahl der Winkellagen des Bonddrahtes bei der Gruppe von Bondverbindungen, derart ausgewählt wird, dass die Abweichung gegenüber der Winkellage des Bonddrahtes bei jeder zu erzeugenden Bondverbindungen minimal wird.

4. Verfahren nach einem der vorangehenden Ansprüche, wobei eine Einrichtung zum Abflammen eines Bond-Tailes zusammen mit dem Bondkopf der Winkellage des Bonddrahtes nachgeführt wird.

5. Verfahren nach einem der vorangehenden Ansprüche, wobei die Substrate für die Gruppe von Bondverbindungen konzentrisch um ein Arbeitstisch-Zentrum arrangiert werden, so dass die jeweiligen Bonddrähte mit durch die Größe der Gruppe bestimmten Winkelinkrementen radial verlaufen und der Bondkopf und optional die Abflammeinrichtung zwischen aufeinanderfolgenden Bondschritten um die gleichen Winkelinkremente gedreht werden.

6. Drahtbonder zur Herstellung von Golddraht-Bondverbindungen, mit einem mit Ultraschall beaufschlagbaren und gegen den Bonddraht auf einem Substrat andrückbaren Bondwerkzeug, das in einem Bondkopf gehaltert ist, wobei der Bondkopf mit dem Bondwerkzeug drehbar gelagert und eine Steuer- und Antriebseinrichtung zum Drehen des Bondkopfes in vorbestimmte Winkellagen bezüglich einer festen Raumrichtung vorgesehen ist.

7. Drahtbonder nach Anspruch 6, wobei die Steuer- und Antriebseinrichtung zur Programmierung einer Gruppe von Winkellagen des Bondkopfes und zur Ausführung einer Drehbewegungs-Abfolge zur sequenziellen Überführung des Bondkopfes in die vorbestimmten Winkellagen ausgebildet sind.

8. Drahtbonder nach Anspruch 6 oder 7, wobei der Bondkopf eine Abflammeinrichtung zum Abflammen eines Bond-Tailes aufweist, welche aus einer vom Bondwerkzeug entfernten in eine zum Bondwerkzeug benachbarten Lage verfahrbar und zusammen mit dem Bondkopf drehbar ist.

9. Drahtbonder nach Anspruch 8, wobei der Abflammeinrichtung eine Kurvenscheibeneinrichtung zur Steuerung einer vorbestimmten Bewegungsbahn im Ansprechen auf die Ausführung eines Bondschrittes zugeordnet ist.
